# EUROPÄISCHE PATENTSCHRIFT

(11) **EP 0 729 520 B1**
(45) Veröffentlichungstag und Bekanntmachung des Hinweises auf die Patenterteilung: **03.05.2000**
(21) Anmeldenummer: 94931502.2
(22) Anmeldetag: 28.10.1994
(51) Int. Cl.: C23C 14/28

(54) **VERFAHREN ZUR INNENWANDBESCHICHTUNG VON HOHLKÖPERN, INSBESONDERE KLEINER ABMESSUNGEN**
METHOD FOR COATING THE INSIDE WALLS OF HOLLOW ARTICLES, IN PARTICULAR OF SMALL DIMENSIONS
PROCEDE PERMETTANT DE REVETIR LES PAROIS INTERNES DE CORPS CREUX, EN PARTICULIER DE CORPS DE DIMENSIONS REDUITES

(30) Priorität: 19.11.1993 DE 4339490
(43) Veröffentlichungstag der Anmeldung: 04.09.1996
(73) Patentinhaber: FRAUNHOFER-GESELLSCHAFT ZUR FÖRDERUNG DER ANGEWANDTEN FORSCHUNG E.V., 80636 München (DE); MAT GmbH, 01257 Dresden (DE)
(72) Erfinder: MUCHA, Andreas, D-01728 Bannewitz (DE); MAI, Hermann, D-01067 Dresden (DE); DIETSCH, Reiner, D-01187 Dresden (DE)
(86) Internationale Anmeldenummer: DE9401285
(87) Internationale Veröffentlichungsnummer: WO9514114

(56) Entgegenhaltungen:
- DD-A- 252 845
- DE-A- 3 800 680
- FR-A- 2 607 830
- US-A- 5 372 862
- Patent Abstracts of Japan, Band 12, Nr 47(C-475); & JP,A,62192578 (MITSUBISHI ELECTRIC CORP), 1987-08-24
- Patent Abstracts of Japan, Band 12, Nr 47(C-475); & JP,A,62192579 (MITSUBISHI ELECTRIC CORP), 1987-08-24
- EUROPEAN MATERIALS RESEARCH SOCIETY MONOGRAPHS vol. 4, 1992, DREYFUS R.W. "Comparison of the Ablation of Dielectrics and Metals at High and Low Laser Powers", p. 61 - 72

## Beschreibung

Die Erfindung bezieht sich allgemein auf das Gebiet der Dünnschichttechnologie und speziell auf die Abscheidung dünner und dünnster Schichten mittels Laserimpuls-Gasphasenabscheidung (PLD; engl.: Pulsed Laser Deposition) im Vakuum bzw. in definierter Gasatmosphäre. Die Erfindung ist dort anwendbar, wo auf die Innenwände von Hohlkörpern, beispielsweise Rohren, aus leitenden und/oder nichtleitenden Materialien, insbesondere mit kleinen Abmessungen, dünne Schichten aus bestimmten Materialien bzw. Materialkombinationen zu sowohl funktionellen als auch dekorativen Zwecken abgeschieden werden sollen.

Es sind allgemein eine Reihe von Verfahren bekannt, mit denen dünne und dünnste Schichten auf Substraten abgeschieden werden. Diese Verfahren sind jedoch zumeist bedingt durch die Größe der dazu notwendigen Vorrichtungen und Anordnungen zur Innenwandbeschichtung von Hohlkörpern (z.B. Rohre oder ähnliche Bauteile) ungeeignet.

Darüber hinaus sind einige Verfahren bekannt, die eine Innenwandbeschichtung von Rohren an Luft oder im Vakuum durch Beschichtung mittels Bedampfen, Bestäuben usw. ermöglichen.

So ist z.B. in der EP 0 298 157 A1 ein Verfahren zur Innenwandbeschichtung von Rohren beschrieben, bei dem zwischen einem eingebauten Innenleiter und dem Rohr selbst als eine Elektrode ein Vakuumbeschichtungsverfahren angeregt wird, und eine Vorrichtung zu Durchführung dieses Verfahrens dokumentiert wird.

Die da beschriebene Lösung hat den Nachteil, daß ihrem Anwendungsbereich, durch das Material, aus dem das zu beschichtende Rohr besteht, enge Grenzen gesetzt sind, da zur Durchführung dieses Verfahrens die Innenwand des zu beschichtenden Rohres unbedingt elektrisch leitfähig sein muß. Das bedeutet, daß Hohlkörper aus nichtleitendem Material, wie z.B. Keramik, allein durch das dort beschriebene Verfahren nicht zu beschichten sind.

Aus diesem Grund ist es erforderlich, zur Innenwandbeschichtung z.B. von Keramikrohren nach dem in der oben genannten EP 0 298 157 A1 beschriebenen Verfahren diesem noch ein weiteres, anderes Beschichtungsverfahren vorzuschalten, um auf die Innenwand des z.B. Keramikrohres zunächst eine elektrisch leitfähige Schicht aufzubringen. Dieses vorgeschaltete weitere Beschichtungsverfahren erhöht den Aufwand zur Beschichtung von Hohlkörpern nach einem solchen Verfahren derart, daß man praktisch davon ausgehen kann, daß es zur Innenwandbeschichtung von Hohlkörpern aus elektrisch nichtleitendem Material ungeeignet ist.

Des weiteren ist ebenfalls in EP 0 298 157 A1 eine Methode zur Innenwandbeschichtung von Rohren mittels Sputtern beschrieben, bei dem die komplette Sputtereinrichtung im Rohr bewegt wird. Durch Auswahl geeigneter Aufstäubungstechniken (z.B. Hochfrequenz-Anregung) können mit dieser Verfahrensweise auch elektrisch nichtleitende Beschichtungsmaterialien aufgebracht werden.

Bei Anwendung dieser Methode ist besonders nachteilig, daß der zu beschichtende Innenraum des Rohres bestimmte Mindestabmessungen nicht unterschreiten darf. Dies ist erforderlich, da zum einen die Sputtereinrichtung, die auch nicht beliebig klein gehalten werden kann, im Hohlkörper bewegt werden muß und zum anderen, um einen funktionierenden Abscheideprozess, der einen physikalisch begründeten Mindestabstand zwischen Sputterkathode und Rohrinnenwand erfordert, zu garantieren.

Desweiteren sind in FR-A-2 607 830, JP 62-174 369, JP 62-274 064, JP 62-192 578, JP 62-192 579, JP 63-290 264 und JP 04-165 070 Verfahren zur Innenwandbeschichtung von Rohren entweder mittels Laserstrahlverdampfung (FR-OS 2 607 830, JP 62-174 369, JP 62-274 064, JP 62-192 578, JP 62-192 579 und JP 63-290 264) oder mittels Sputtern (JP 04-165 070) beschrieben.

Ein Nachteil dieser Verfahren, der auch auf die anderen zum Stand der Technik zählenden Verfahren zur Innenwandbeschichtung von Hohlkörpern zutrifft, besteht darin, daß mit diesen Verfahren ausschließlich die Beschichtung der Innenwände von Rohren bzw. rohrähnlichen Bauteilen möglich ist.

Aufgrund der Nachteile dieser Methoden ist die Innenwandbeschichtung von Hohlkörpern mit stark strukturierten Innenwänden ebenfalls unmöglich.

Der Erfindung liegt nunmehr die Aufgabe zugrunde, ein Verfahren zur Innenwandbeschichtung von Hohlkörpern aufzuzeigen, bei denen aufgrund der Beschaffenheit des Innenraumes des Hohlkörpers die bisher bekannten Verfahren nicht mehr eingesetzt werden können.

Somit besteht die Aufgabe der Erfindung darin, ein Verfahren zur Innenwandbeschichtung von Hohlkörpern anzugeben, mit dem auch die Innenwände von Hohlkörpern mit kleinen Innendurchmessern (< 10mm) beschichtet werden können, dessen Nutzung nicht ausschließlich auf Rohre bzw. rohrähnliche Gebilde beschränkt ist, das bei Hohlkörperinnenwänden aus elektrisch leitenden, halbleitenden und elektrisch nichtleitenden Materialien gleichermaßen anwendbar ist, dessen Anwendung auch bei Strukturierung des zu beschichtenden Innenraumes des Hohlkörpers möglich ist und mit dem trotz der Strukturierung im Innenraum des Hohlkörpers gleichmäßige Schichten mit definiert einstellbarer Dicke über die gesamte zu beschichtende Fläche abgeschieden werden können.

Erfindungsgemäß werden die Aufgaben das Verfahren nach Anspruch 1 gelöst. Bevorzugte Ausführungsformen des Verfahrens sind in den Ansprüchen 2 bis 13 beansprucht.

Unter dem Begriff PLD (Pulsed Laser Deposition) wird dabei ein Gesamtprozess verstanden, der sich in die drei Teilprozesse Laserablation, Plasmaexpansion und Kondensation des Teilchenstromes auf der Oberfläche eines geeigneten Substrates gliedert.

Unter Laserablation versteht man dabei das Entfernen von Atomen, Molekülen und/oder Clustern von Festkörperoberflächen oder biologischem Gewebe mittels fokussierter Laserstrahlung durch nichtthermisches Abtragen (Laser 2000 Förderungskonzept 1993 - 1997 BMFT, Bonn 1994, S. 65).

Bei diesem Prozess wird die Oberfläche eines Festkörpertargets mit extrem kurzen Laserimpulsen sehr hoher Impulsleistungsdichte bestrahlt. Bei einer kritischen Leistungsdichte um 100 MW/cm² wird das Target nur im unmittelbaren Einwirkungsbereich hochangeregt und es findet ein deutlicher Materialabtrag statt. Der Prozess wird im wesentlichen durch die Parameter des Laserstrahles (Wellenlänge λ, Impulsenergie E_{ρ}, Impulslänge τ_{ρ} und Impulsleistungsdichte N₁) und die Festkörpereigenschaften des Targets (Absorptionstiefe des Laserlichtes, Wärmeleitung im Material) bestimmt und ist auf den unmittelbaren Wechselwirkungsbereich des Laserimpulses mit der Targetoberfläche begrenzt.

Im Unterschied zur Laserablation erfolgt bei der Laserverdampfung, auf der auch die Mehrzahl der im Stand der Technik genannten Verfahren basieren, die Teilchenemission aus der Schmelze. Dazu muß das gesamte Targetmaterial durch Laserbestrahlung bis zur Schmelztemperatur erwärmt werden.

An den Teilprozeß der Laserablation schließt sich der Teilprozeß der Plasmaexpansion an. Dieser Teilprozeß wird dahingehend verstanden, daß die sich im Ergebnis der Laserablation bildende Plasmawolke durch einen hohen Ionisierungsgrad und Teilchenenergien bis zu mehreren 100 eV gekennzeichnet ist. Sie zeigt eine rotationssymmetrische Emissionscharakteristik mit einer in Richtung der Targetnormalen liegenden Symmetrieachse. Form und Ausbreitungsrichtung der Plasmawolke können durch elektrische bzw. elektromagnetische Felder beeinflußt werden.

Dagegen sind für die Verdampfung Teilchenenergien unterhalb 1eV sowie geringe Ionisationsgrade typisch. Damit ist der Teilchenstrom in der Dampfwolke (vergl. Stand der Technik) durch elektrische bzw. elektromagnetische Felder nur in geringem Maße beeinflußbar.

Die Kondensationsphase als dritter Teilprozeß der PLD beinhaltet die Kondensation des Teilchenstromes auf der Substratoberfläche. Diese Kondensation und das daraus resultierende Schichtwachstum werden im wesentlichen durch den Impulscharakter des PLD-Verfahrens bestimmt. Die sehr hohen Teilchen- und Energiestromdichten pro Impuls bewirken ein Schichtwachstum fernab vom thermodynamischen Gleichgewicht.

Bei dem erfindungsgemäßen Verfahren wird im Inneren des Hohlkörpers ein Target aus dem Material der aufzubringenden Schicht angebracht. Der Hohlkörper befindet sich in einer Vakuumkammer bzw. kann bei geeigneten Abmessungen und geeigneter Geometrie, was beinhaltet, daß der Hohlkörper selbst vakuumgeeignet, wie z.B. aus vakuumdichtem und dem äußeren Luftdruck standhaltendem Material besteht und Vakuumpumpen angeschlossen werden können, ist und den Anforderungen an eine Vakuumkammer genügt, vorteilhafterweise selbst als Vakuumkammer ausgebildet sein. Dabei kann die Vakuumkammer sowohl als solche, als auch als Reaktionskammer mit definierter Gasatmosphäre betrieben werden. Auf die Spitze des im Hohlkörper angebrachten Targets, auf der der Materialabtrag stattfindet, wird der fokussierte Strahl eines Impulslasers gerichtet, wobei diese Fokussierung vorzugsweise mittels einer Sammellinse, die außerhalb der Vakuumkammer angeordnet sein kann, erfolgt. Die durch den Impulsbeschuß erzeugte Plasmafackel wird durch die geeignet gewählte geometrische Form der Targetspitze, deren Oberfläche auch als Ablationsfläche bezeichnet werden kann, in Richtung der Innenwände des zu beschichtenden Hohlkörpers gerichtet. Der Impulslaserstrahl gelangt über ein Laserstrahleintrittsfenster aus für den verwendeten Laserwellenlängenbereich transparentem Material in den Hohlkörper auf die Targetspitze, an der der Materialabtrag stattfindet. Es ist von Vorteil, wenn die Richtung der Oberflächennormalen der Targetspitze zur Richtung des einfallenden Laserstrahles geneigt ist. Damit wird erreicht, daß ein gezieltes Auslenken der Plasmafackel in Abhängigkeit von der Normalenrichtung der Targetoberfläche weitestgehend unabhängig von der Richtung des einfallenden Laserstrahles erfolgt.

Um eine optimale und gleichmäßige Schichtabscheidung zu erreichen, ist es günstig, wenn der innen zu beschichtende Hohlkörper als Substrat und das Target unabhängig voneinander bewegt werden. Das kann beispielsweise derart erfolgen, daß der Hohlkörper (Substrat) relativ zum Target in mehreren Richtungen bewegt wird und das im Hohlkörper befindliche Target eine Drehbewegung um eine in Strahleinfallsrichtung zeigende Achse ausführt. Mit dieser Relativbewegung Substrat - Target wird gleichzeitig ein gleichmäßiger, flächenhafter Materialabtrag an der Targetspitze erreicht.

Es ist ebenso vorteilhaft, wenn die durch den Impulsbeschuß erzeugte Plasmafackel über die Innenwand des zu beschichtenden Hohlkörpers geführt wird, indem der Impulslaserstrahl entsprechend der Geometrie der Targetspitze über die Oberfläche der Targetspitze bewegt wird, wobei der Materialabtrag auf der gesamten Oberfläche der Targetspitze erfolgen sollte. Dabei kann es günstig sein, wenn das Substrat (Hohlkörper) von außen gehalten und entsprechend zur Laser-Targetanordnung bewegt wird.

Eine definierte Einstellung der Dicke bzw. eine definierte Einstellung der Dickenverteilung der auf der Innenwand des Hohlkörpers abgeschiedenen Schicht wird durch eine gezielte Relativbewegung zwischen Laserstrahl, Target und Substrat erreicht.

Für den Fall, daß der Hohlkörper (Substrat) selbst als Vakuumkammer dient und dieser Hohlkörper aus im verwendeten Laserwellenlängenbereich transparentem Material besteht, kann in bestimmten Fällen auf ein gesondertes Laserstrahleintrittsfenster verzichtet werden und der Laserstrahl kann direkt durch das Hohlkörpersubstratmaterial auf die Targetspitze gerichtet werden.

Die Vorrichtung zur Durchführung des Verfahrens zur Innenwandbeschichtung von Hohlkörpern besteht aus einer Laserstrahlführung, in der eine Sammellinse zur Fokussierung des Impulslaserstrahles, die außerhalb der Vakuumkammer angeordnet sein kann, angeordnet ist, einem Laserstrahleintrittsfenster aus im verwendeten Laserwellenlängenbereich transparentem Material an der Eintrittsstelle des Laserstrahles in die Vakuumkammer, auf das bei Hohlkörpern aus im verwendeten Laserwellenlängenbereich transparentem Material in bestimmten Fällen verzichtet werden kann, und den entsprechenden Vorrichtungen zur Target- bzw. Substratauf-nahme und -bewegung. Diese Vorrichtungen zur Target- bzw. Substrathalterung und -bewegung sind ebenso wie der innen zu beschichtende Hohlkörper als Substrat, in dem sich das Target aus dem Material der aufzubringenden Schicht befindet, innerhalb der Vakuumkammer angebracht. Der Antrieb der Target- und Substratbewegung erfolgt über entsprechende Bewegungsdurchführungen, die an der Vakuumkammer angebracht sind. Sollte das Hohlkörpersubstrat jedoch selbst die Funktion der Vakuumkammer übernehmen, was fallweise vorteilhaft sein kann, so ist ausschließlich das Target innerhalb der Vakuumkammer und alle anderen Bestandteile befinden sich außerhalb.

Fallweise kann es sich ebenfalls als vorteilhaft erweisen, daß die Sammellinse zur Fokussierung des Impulslaserstrahles nicht außerhalb der Vakuumkammer angeordnet ist, sondern selbst als Strahleintrittsfenster in die Vakuumkammer dient.

Eine besonders vorteilhafte Anwendung dieses erfindungsgemäßen Verfahrens besteht in der Innenwandbeschichtung von Rohren, speziell solcher Rohre, deren Innendurchmesser kleiner als 10 mm ist, sowie von Formkörpern, beispielsweise Reagenzgläsern, die nur über eine Öffnung verfügen, sowie von schwer erreichbaren inneren Oberflächenbereichen, wie sie z.B. bei hinterschnittenen Innengewinden auftreten.

Mit der vorangehend beschriebenen erfindungsgemäßen Lösung konnte die zugrunde liegende Aufgabe in allen Bereichen vollständig gelöst werden.

Durch die Anwendung dieser erfindungsgemäßen Lösung wird es möglich, die Innenwände von Hohlkörpern, die eine solche Abmessung bzw. Strukturierung besitzen, daß herkömmliche Beschichtungsverfahren nicht mehr eingesetzt werden können, zu beschichten. Ein besonderer Vorteil des Verfahrens dabei ist, daß die Abscheidung auf Substraten aus leitendem, halbleitendem bzw. nichtleitendem Material ohne Einschränkungen möglich ist. Weiterhin bietet die erfindungsgemäße Lösung den Vorteil, daß auch auf die Innenwände unterschiedlichst strukturierter Hohlkörper Schichten mit gleichmäßiger Dicke bzw. gezielter Schichtdickenverteilung abgeschieden werden können.

Bisher war es nach dem Stand der Technik nicht möglich, Rohre mit einem Innendurchmesser kleiner 10 mm innen zu beschichten. Mit der erfindungsgemäßen Lösung ist auch für Rohre, deren Innendurchmesser nur 4 bis 5 mm sein kann, eine Innenwandbeschichtung möglich. Die innen zu beschichtenden Rohre können bei Anwendung der erfindungsgemäßen Lösung auch im Verhältnis zum Innendurchmesser große Längen aufweisen. Ein weiterer Vorteil der vorgeschlagenen Lösung besteht darin, daß durch den Impulsbetrieb während des Materialabtrages der Energie-übertrag auf das Substrat und damit die Substrattemperatur gering gehalten werden können. Weiterhin unterbleibt dabei die Aufheizung des gesamten Targets, da die Wechselwirkung zwischen Laserstrahl und Target auf den eigentlichen Strahlquerschnitt beschränkt bleibt. Das bedeutet, daß nur dieses Gebiet aufgeheizt wird, während die restliche Targetmasse und die Halterung auf Raumtemperatur verbleiben.

Mit der erfindungsgemäßen Lösung können nahezu alle reinen Stoffe abgeschieden werden und die Abscheidung ist auf Substraten aus beliebigen Materialien (Leiter, Halbleiter, Nichtleiter) möglich.

Bei geeigneten Abmessungen kann das Hohlkörpersubstrat selbst als Vakuumkammer dienen, was einen ökonomischen Vorteil hinsichtlich des Aufwandes für die Vakuumerzeugung und die Substrathalterung und -bewegung bedeutet.

Außerdem ist die erfindungsgemäße Lösung vorteilhafterweise mit anderen Verfahren zur Innenwandbeschichtung, beispielsweise von Rohren, kombinierbar. So kann z.B. bei ausreichend großem Innendurchmesser ein Rohr aus einem nichtleitenden Material zunächst nach der erfindungsgemäßen Lösung innen mit einer dünnen leitenden Schicht versehen werden und anschließend nach der EP 0 298 157 A1 weiterbeschichtet werden. Besteht das Rohr beispielsweise aus einem nichtleitenden Material (z.B. Keramik), so kann die erfindungsgemäß aufgebrachte dünne Schicht aus einem leitenden Material, die gleichzeitig als Haftvermittler dienen kann, auch nach einem galvanischen Verfahren weiter verstärkt werden. Das bedeutet, daß mit der erfindungsgemäßen Lösung auch den bekannten Verfahren zur Innenwandbeschichtung von Rohren neue Anwendungsmöglichkeiten erschlossen werden.

Die erfindungsgemäße Lösung soll an nachfolgendem Ausführungsbeispiel näher erläutert werden.

Das Prinzip des Verfahrens und der Vorrichtung soll anhand der Beschichtung der Innenwand von Rohren gezeigt werden. Die Beschichtung erfolgt im Vakuum, wobei es ausreichend sein kann, daß das Rohr (5) selbst die Vakuumkammer ist.

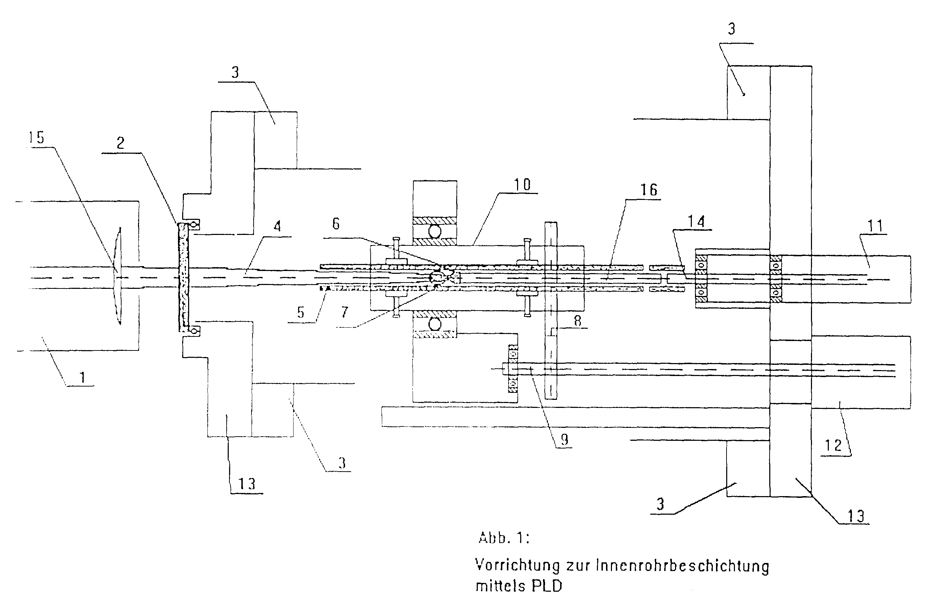

Der schematische Aufbau der Vorrichtung ist in Abb. 1 dargestellt. Im Inneren des zu beschichtenden Rohres (5) befindet sich ein Targethalter (16), auf dessen Spitze ein Target (6) aus dem abzuscheidenden Material aufgesetzt ist. Mit Hilfe einer Sammellinse (15), die sich in einem festen Abstand gegenüber der Targetspitze in der Laserstrahlführung (1) befindet, wird der fokussierte Strahl (4) eines Impulslasers durch ein Strahleintrittsfenster (2) geführt und auf die Targetspitze gerichtet. Die Laserstrahlführung erfolgt im allgemeinen in einem abgeschirmten Lichtkanal, in dem sich weiterhin eine teleskopartige Optik zur Strahlformung befinden kann bzw. über Lichtleitkabel. Der Durchmesser des gepulsten Laserstrahles (4) oder seine Position auf der Targetspitze ist so gewählt, daß der Materialabtrag auf der gesamten Oberfläche der Targetspitze erfolgt. Die Richtung der Oberflächennormalen der Targetspitze ist zur Richtung des einfallenden Laserstrahles (4) geneigt. Dadurch zeigt die Ausbreitungsrichtung der Plasmafackel (7), die weitestgehend unabhängig vom Einfallswinkel des Laserstrahles (4) annähernd in Oberflächennormalenrichtung des Targets (6) verläuft, zur zu beschichtenden Innenwand.

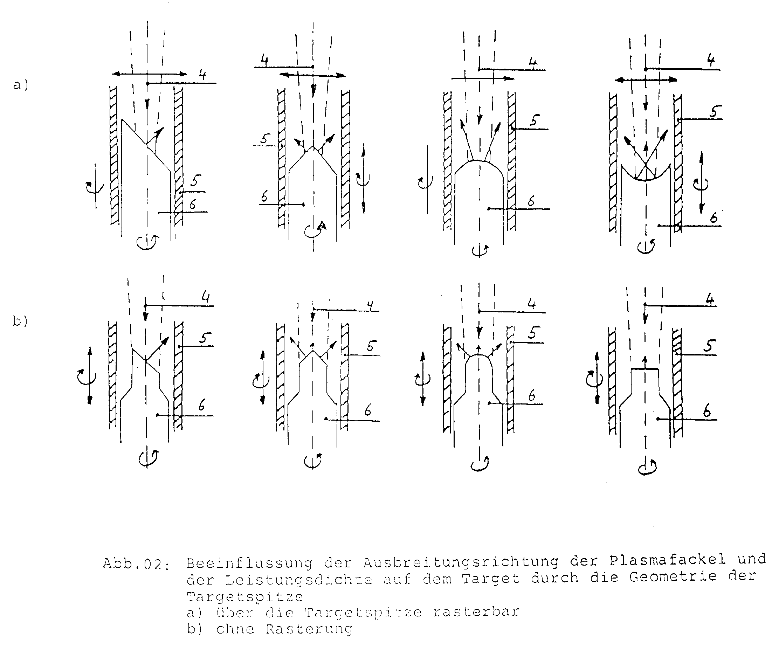

In Abb. 2 sind mögliche geometrische Formen der Targetspitze und die daraus resultierende Ausbreitungsrichtung der Plasmafackel dargestellt. Um eine gleichmäßige Schichtdickenverteilung über den Umfang des Rohres (5) zu erreichen, wird das Target (6) mittels eines Antriebes (14) gedreht. Das zu beschichtende Rohr (5) befindet sich in einer Substrathalterung (10) und wird über den Targethalter (16) mit aufgesetztem Target (6) geschoben. Die zur Beschichtung benutzte Vorrichtung gestattet, mittels einer kombinierten Dreh-Schiebedurchführung (12) mit deren Antrieben (8, 9) sowohl die Drehung des Rohres (5), als auch die Verschiebung des Rohres (5) entlang der Strahl- bzw. Targetachse. Sinnvollerweise erfolgt die Drehung des Targets (6) entgegen der Drehrichtung des Rohres (5).

Zu Beginn des Beschichtungsprozesses befindet sich die Targetspitze an der dem Strahl (4) zugewandten Seite des Rohres (5). Während des Beschichtungsprozesses wird das Rohr (5) bei gleichzeitiger Drehung entgegengesetzt zur Drehrichtung des Targets (6) in Richtung der Sammellinse (15) so verschoben, daß im Inneren des Rohres (5) eine Schicht mit gleichmäßiger Dicke bzw. mit gezielter Dickenverteilung abgeschieden wird. Target (6) und Substrat (5) sind in einer HV- bzw. UHV-Apparatur angeordnet, an der Basisflansche (13) befestigt sind, auf denen einerseits die Bewegungsdurchführungen für die Target- (11) und die Substratbewegung (12) sowie die Vorrichtung zur Target- und Substrathalterung und andererseits ein Strahleintrittsfenster (2) zur Durchführung des Laserstrahles angebracht sind. In der hier dargestellten Vorrichtung wurden nach dem genannten Verfahren unter anderem die Innenwände von Keramikrohren mit einem Innendurchmesser von 7 mm beschichtet. Mit den abgeschiedenen Schichten konnte die Lösung der gestellten Aufgabe nachgewiesen werden.

### Bezugszeichenliste

- 1: Laserstrahlführung (teleskopartige Optik, abgeschirmter Lichtkanal, Lichtleitkabel) mit Strahlfokussierung
- 2: Strahleintrittfenster
- 3: Anschlußflansche der Beschichtungskammer
- 4: gepulster Laserstrahl
- 5: innen zu beschichtender Hohlkörper (Rohr) als Substrat
- 6: Target
- 7: Plasmafackel
- 8: Antrieb zur Substratrotation
- 9: Antrieb zur Substratverschiebung
- 10: Substrathalterung
- 11: Drehdurchführung für Targetrotation
- 12: Dreh-, Schiebe-Durchführung für Substratrotation und -verschiebung
- 13: Basisflansch mit Vorrichtungen für Target- und Substrathalterung bzw. -bewegung
- 14: Antrieb zur Targetrotation
- 15: Sammellinse
- 16: Targethalter

## Patentansprüche

1. Verfahren zur Innenwandbeschichtung von Hohlkörpern, insbesondere kleiner Abmessungen mit Innendurchmessern < 10 mm, deren Innenwände auch unterschiedlichst strukturiert sein können, **dadurch gekennzeichnet,** daß diese Innenwandbeschichtung mittels PLD (Pulsed Laser Deposition) durchgeführt wird, wobei im Inneren des zu beschichtenden Hohlkörpers, der sich in einer Vakuumkammer befindet, ein Target aus dem Material der aufzubringen Schicht angebracht wird, auf die Oberfläche des Targets, auf der der Materialabtrag mittels Laserablation stattfindet, der fokussierte Strahl eines Impulslasers gerichtet wird und die Hauptausbreitungsrichtung der durch den Impulslaserbeschuß erzeugten Plasmafackel durch eine geeignet gewählte geometrische Form der Oberfläche des Targets in Richtung der Innenwände des zu beschichtenden Hohlkörpers gerichtet wird.

2. Verfahren nach Anspruch 1, **dadurch gekennzeichnet,** daß die Richtung der Oberflächennormale der Targetspitze zur Richtung des einfallenden Laserstrahles geneigt wird.

3. Verfahren nach Anspruch 1 oder 2, **dadurch gekennzeichnet,** daß zur optimalen gleichmäßigen Schichtabscheidung der innen zu beschichtende Hohlkörper als Substrat und das Target unabhängig voneinander bewegt werden.

4. Verfahren nach Anspruch 3, **dadurch gekennzeichnet,** daß während der Innenwandbeschichtung des Hohlkörpers dieser relativ zum Target in mehreren Richtungen bewegt wird, und daß das im Hohlkörper befindliche Target einer Drehbewegung um eine zur Strahleinfallsrichtung zeigende Achse unterworfen wird.

5. Verfahren nach Anspruch 1, dadurch gekennzeichnet, daß der Impulslaserstrahl über ein Strahleintrittsfenster auf das sich im Inneren des zu beschichtenden Hohlkörpers angebrachte Target geführt wird.

6. Verfahren nach Anspruch 1, **dadurch gekennzeichnet,** daß der innen zu beschichtende Hohlkörper selbst als Vakuumkammer dient, wenn er den technischen Anforderungen an eine Vakuumkammer entspricht, und die dafür geeigneten Abmessungen und Geometrie aufweist.

7. Verfahren nach Anspruch 6, **dadurch gekennzeichnet,** daß die Vakuumkammer sowohl als Vakuumkammer als auch als Reaktionssystem mit definierter Gasatmosphäre betrieben wird.

8. Verfahren nach Anspruch 5 und 6, **dadurch gekennzeichnet,** daß bei im verwendeten Laserwellenlängenbereich transparenten Hohlkörpersubstratmaterial auf ein gesondertes Laserstrahleintrittsfenster verzichtet und der Laserstrahl direkt durch das Hohlkörpersubstratmaterial auf die Oberfläche der Targetspitze geführt wird.

9. Verfahren nach Anspruch 1, **dadurch gekennzeichnet,** daß der Impulslaserstrahl mittels einer Sammellinse fokussiert und auf die Oberfläche der Targetspitze gerichtet wird.

10. Verfahren nach Anspruch 1 oder 2, **dadurch gekennzeichnet,** daß die durch den Impulsbeschuß erzeugte Plasmafackel über die Innenwand des Hohlkörpers geführt wird, indem der Impulslaserstrahl in Abhängigkeit von der Targetgeometrie über die Oberfläche der Targetspitze bewegt wird.

11. Verfahren nach einem oder mehreren der Ansprüche 1, 2 oder 10, **dadurch gekennzeichnet,** daß der Materialabtrag auf der gesamten Oberfläche der Targetspitze stattfindet.

12. Verfahren nach einem oder mehreren der Ansprüche 1 bis 11, **dadurch gekennzeichnet,** daß das Hohlkörpersubstrat von außen gehalten und entsprechend zur Laser-Target-Anordnung bewegt wird.

13. Verfahren nach einem oder mehreren der Ansprüche 1 bis 12, **dadurch gekennzeichet,** daß eine definierte Dicke, bzw. definierte Dickenverteilung der auf der Innenwand des zu beschichtenden Hohlkörpersubstrates abgeschiedenen Schicht durch eine gezielte Relativbewegung zwischen Laserstrahl, Target und Substrat eingestellt wird.

## Claims

1. A method of inner wall coating of hollow bodies, especially of small dimensions with internal diameters < 10 mm, whose inner walls can also be variously structured, characterized in that this inner wall coating is effected by means of PLD (pulsed laser deposition), wherein a target of the material of the layer to be applied is placed in the interior of the hollow body to be coated, which is present in a vacuum chamber, the focused beam of a pulsed laser is directed on to the surface of the target, at which erosion of material by means of laser ablation takes place and the main direction of propagation of the plasma torch created by the pulsed laser bombardment is directed in the direction of the inner wall of the hollow body to be coated by a suitably selected geometrical form of the surface of the target.

2. A method according to claim 1, characterized in that the direction of the normal to the surface of the target tip is inclined to the direction of the incident laser beam.

3. A method according to claim 1 or 2, characterized in that the hollow body to be coated internally as substrate and the target are moved independently of one another for optimally uniform coating deposition.

4. A method according to claim 3, characterized in that the hollow body is moved in a plurality of directions relative to the target during the inner wall coating thereof and in that the target located in the hollow body is subjected to rotational movement about an axis pointing in the direction of incidence of the beam.

5. A method according to claim 1, characterized in that the pulsed laser beam is passed through a beam entrance window on to the target placed in the interior of the hollow body to be coated.

6. A method according to claim 1, characterized in that the hollow body to be coated inside serves itself as the vacuum chamber, when it meets the technical requirements of a vacuum chamber and has dimensions and geometry suited to this.

7. A method according to claim 6, characterized in that the vacuum chamber is operated both as a vacuum chamber and as a reaction system with a defined gas atmosphere.

8. A method according to claim 5 or 6, characterized in that a separate laser beam entrance window is dispensed with in the case of a hollow body substrate material transparent to the laser wavelength range employed and the laser beam is passed directly through the hollow body substrate material on to the surface of the target tip.

9. A method according to claim 1, characterized in that the pulsed laser beam is focused by means of a condenser lens and is directed on to the surface of the target tip.

10. A method according to claim 1 or 2, characterized in that the plasma torch created by the pulsed bombardment is passed over the inner wall of the hollow body, in that the laser beam is moved over the surface of the target tip in dependence on the target geometry.

11. A method according to one or more of claims 1, 2 and 10, characterized in that the material erosion takes place over the whole surface of the target tip.

12. A method according to one or more of claims 1 to 11, characterized in that the hollow body is held on the outside and is moved in accordance with the laser-target arrangement.

13. A method according to one or more of claims 1 to 12, characterized in that a defined thickness or defined thickness distribution of the layer deposited on the inner wall of the hollow body substrate to be coated is adjusted by specific relative movement between the laser beam, target and substrate.

## Revendications

1. Procédé de revêtement de la paroi intérieure de corps creux notamment de petites dimensions, ayant un diamètre intérieur < 10 mm, dont la paroi intérieure peut avoir une structure très différente,
caractérisé en ce qu'
- on effectue le revêtement de la paroi intérieure par un dépôt par faisceau laser pulsé (procédé PLD) et, pour cela, on place à l'intérieur du corps creux à revêtir, dans une enceinte à vide, une cible réalisée dans la matière de la couche à appliquer,
- on effectue une ablation par laser de la surface de la cible en dirigeant le faisceau focalisé d'un laser impulsionnel et,
- on détermine la direction d'extension principale de la torche de plasma générée par le bombardement par faisceau laser impulsionnel, par une forme géométrique choisie de manière appropriée de la surface de la cible en direction de la paroi intérieure du corps creux à revêtir.

2. Procédé selon la revendication 1,
caractérisé en ce que
la direction de la normale à la surface de la pointe de la cible, est inclinée en direction du faisceau laser incident.

3. Procédé selon la revendication 1 ou 2,
caractérisé en ce qu'
on déplace indépendamment le corps creux à revêtir, constituant le support et la cible, pour un dépôt régulier optimum de la couche.

4. Procédé selon la revendication 3,
caractérisé en ce que
- pendant le revêtement de la paroi intérieure du corps creux, on déplace celui-ci dans plusieurs directions par rapport à la cible et,
- on communique à la cible, à l'intérieur du corps creux, un mouvement de rotation autour d'un axe dirigé dans la direction du rayonnement incident.

5. Procédé selon la revendication 1,
caractérisé en ce qu'
on guide le faisceau laser impulsionnel à travers une fenêtre d'entrée, sur la cible logée à l'intérieur du corps creux à revêtir.

6. Procédé selon la revendication 1,
caractérisé en ce que
le corps creux à revêtir constitue lui-même l'enceinte à vide s'il correspond aux exigences techniques d'une enceinte à vide et possède les dimensions et la géométrie appropriées.

7. Procédé selon la revendication 6,
caractérisé en ce que
la chambre à vide fonctionne à la fois comme chambre à vide et comme système de réaction ayant une atmosphère gazeuse définie.

8. Procédé selon les revendications 5 et 6,
caractérisé en ce que
dans le cas d'un corps creux dont la matière est transparente pour la plage des longueurs d'onde laser utilisées, on supprime une fenêtre d'entrée de faisceau laser particulière et on dirige le faisceau laser directement à travers la matière du corps creux, sur la surface de la pointe de la cible.

9. Procédé selon la revendication 1,
caractérisé en ce qu'
on focalise le faisceau laser impulsionnel à l'aide d'une lentille collimatrice et on dirige le faisceau sur la surface de la pointe de la cible.

10. Procédé selon les revendications 1 ou 2,
caractérisé en ce que
la torche de plasma générée par le bombardement impulsionnel est conduite sur la paroi intérieure du corps creux en déplaçant le faisceau laser impulsionnel, selon la géométrie de la cible, par-dessus la surface de la pointe de la cible.

11. Procédé selon l'une ou plusieurs des revendications 1, 2 ou 10,
caractérisé en ce que
l'enlèvement de matière se fait sur toute la surface de la pointe de la cible.

12. Procédé selon l'une ou plusieurs des revendications 1 à 11,
caractérisé en ce que
le corps creux constituant le substrat est maintenu de l'extérieur et déplacé suivant la disposition laser-cible.

13. Procédé selon l'une ou plusieurs des revendications 1 à 12,
caractérisé en ce qu'
on réalise une épaisseur définie ou une répartition d'épaisseur définie de la couche déposée sur la paroi intérieure du corps creux à revêtir, par un mouvement relatif commandé entre le faisceau laser, la cible et le substrat.
